**Europäisches Patentamt**

**European Patent Office**

**Office européen des brevets**

(11) Veröffentlichungsnummer: **0 075 794**
**B1**

(12) # EUROPÄISCHE PATENTSCHRIFT

(45) Veröffentlichungstag der Patentschrift:
02.05.85

(51) Int. Cl.⁴: **H 02 P 7/62**, G 01 R 31/34

(21) Anmeldenummer: **82108560.2**

(22) Anmeldetag: **16.09.82**

(54) **Verfahren zur Nachbildung des Maschinenflusses einer Drehfeldmaschine und Schaltungsanordnung zur Durchführung des Verfahrens.**

(30) Priorität: **28.09.81 DE 3138557**

(43) Veröffentlichungstag der Anmeldung:
**06.04.83 Patentblatt 83/14**

(45) Bekanntmachung des Hinweises auf die Patenterteilung:
**02.05.85 Patentblatt 85/18**

(84) Benannte Vertragsstaaten:
**AT BE CH DE FR GB IT LI NL SE**

(56) Entgegenhaltungen:
**EP - A - 0 007 552**
**DE - A - 1 806 769**
**FR - A - 2 180 998**
**US - A - 4 245 181**

**REGELUNGSTECHNIK, Band 27, Nr. 12, Dezember 1979, München (DE) R. GABRIEL et al.: "Regelung der stromrichtergespeisten Drehstrom-Asynchronmaschine mit einem Mikrorechner", Seite 379 bis 386**

(73) Patentinhaber: **Siemens Aktiengesellschaft, Berlin und München Wittelsbacherplatz 2, D-8000 München 2 (DE)**

(72) Erfinder: **Heinle, Georg, Dipl.-Ing., Moorbachweg 14, D-8520 Erlangen (DE)**

## Beschreibung

Die Erfindung betrifft ein Verfahren zur Nachbildung des Maschinenflusses einer Drehfeldmaschine aus den Klemmenspannungen und Leiterströmen mindestens zweier Phasen des Stators der Drehfeldmaschine, wobei zur Bildung jeder Komponente des Maschinenflusses eine um den ohmschen Spannungsabfall in einer Phase der Ständerwicklung der Drehfeldmaschine verringerte Klemmenspannung derselben Phase aufintegriert wird und von dem so gewonnenen Integral ein dem aufintegrierten induktiven Spannungsabfall in derselben Phase entsprechender Wert der Drehfeldmaschine subtrahiert wird und eine Schaltungsanordnung zur Durchführung des Verfahrens.

Ein Verfahren der eingangs genannten Art ist aus der DE-AS Nr. 2833593 bekannt.

Zur Regelung von Drehfeldmaschinen wird häufig der magnetische Maschinenfluss nach Betrag und Phase als Istwert benötigt. Daraus kann nämlich das von der Drehfeldmaschine erzeugte Moment, das gleich dem Produkt des Maschinenflusses und der auf dem Fluss senkrecht stehenden Stromkomponente ist, ermittelt werden. Die direkte Ermittlung des Maschinenflusses, beispielsweise durch magnetische Messwertgeber oder durch eine Messwicklung, stösst auf Schwierigkeiten, da derartige Messwertgeber in handelsüblichen Maschinen nicht vorgesehen sind. Nach der genannten DE-AS Nr. 2833593 wird daher der Maschinenfluss mit Hilfe einer Rechenschaltung aus den Klemmenspannungen und den Leiterströmen zweier Phasen der Drehfeldmaschine ermittelt. Diese Rechenschaltung wird als Spannungsmodell der Drehfeldmaschine bezeichnet. Dabei wird von der Tatsache ausgegangen, dass die in den Maschinensträngen induzierte Spannung $u_i$ proportional zur Änderung des Flusses $\emptyset$ und zur Windungszahl w des betreffenden Stranges ist:

$$u_i = w \cdot \frac{d\emptyset}{dt}$$

Man berechnet den Fluss, indem man die in einem Strang der Drehfeldmaschine induzierte Spannung aufintegriert. Die Klemmenspannung der Maschine enthält aber ausser der induzierten Spannung $u_i$ auch die ohmschen und induktiven Spannungsabfälle, die die Ständerströme am Kupferwiderstand des Ständers und an der Streuinduktivität des Ständers hervorrufen. Man korrigiert diese Spannungsabfälle, indem man sie elektronisch nachbildet und von der Klemmenspannung subtrahiert.

Derartige Rechenschaltungen werden z. Zt. ausschliesslich analog realisiert. Im Zusammenwirken mit digitalen Rechenanlagen wäre jedoch eine digitale Realisierung der Rechenschaltung vorteilhaft, da damit der Signalaustausch einfacher wird und die Berechnung des Flusses z. T. unter Einsparung gesonderter Elemente von der digitalen Rechenanlage mit übernommen werden kann.

Eine digitale Realisierung des Spannungsmodells scheiterte bisher an den Schwierigkeiten bei der Analog/Digital-Wandlung der Klemmenspannungen. Bei der Abtastung und Analog/Digital-Wandlung der Klemmenspannungen treten nämlich bei kleinen Drehzahlen unzulässig grosse Fehler auf. Die rührt einerseits daher, dass bei kleinen Drehzahlen die Klemmenspannungen sehr klein werden, so dass die Stufung eines Analog/Digital-Wandlers bereits zu grossen Fehlern führt. Zum anderen enthält die Klemmenspannung steile Kommutierungsspitzen, die insbesondere bei kleinen Drehzahlen im Verhältnis zum Grundanteil der Klemmenspannungen sehr hoch sind. Diese Kommutierungsspitzen werden jedoch bei der Abtastung mit einem Analog/Digital-Wandler nur zufällig getroffen. Bei der anschliessenden Integration wird aber ein zu hoher Betrag aufintegriert, wenn der Abtastzeitpunkt auf eine Kommutierungsspitze gefallen ist oder ein zu niedriger Betrag, wenn die Kommutierungsspitze nicht mit erfasst wurde. Die in der Rechenschaltung enthaltenen Integrierer integrieren jeden Fehler in der Analog/Digital-Wandlung, so dass sehr schnell falsche Werte entstehen.

Aufgabe der Erfindung ist es daher, ein Verfahren zur Nachbildung des Maschinenflusses einer Drehfeldmaschine so auszugestalten, dass es ohne Abtastfehler mit digitalen Grössen durchgeführt werden kann.

Diese Aufgabe wird bei einem Verfahren der eingangs genannten Art erfindungsgemäss dadurch gelöst, dass die Nachbildung des Maschinenflusses mit den digitalisierten, innerhalb der Abtastperiode eines zugehörigen digitalen Auswertesystems gemittelten Werten der Klemmenspannungen und der Leiterströme durchgeführt wird, und dass die Integration durch Aufsummierung der gemittelten Werte und Multiplikation mit der Abtastperiode erfolgt.

Da nach dem erfindungsgemässen Verfahren nicht die aus den genannten Gründen fehlerbehafteten digitalisierten Augenblickswerte der Klemmenspannungen bzw. Leiterströme verwendet werden, sondern deren digitalisierte Mittelwerte, entfällt das Problem des Aufintegrierens von Fehlern bei der digitalen Abtastung. Die Mittelwertbildung beinhaltet nämlich bereits die Integration der Messwerte, die somit vor die Analog/Digital-Umsetzung verlagert wurde. Damit entfällt also das Problem der Abtastung der Kommutierungsspitzen sowie der Verarbeitung von kleinen Klemmenspannungen. Zur Integration der digitalisierten Werte müssen diese lediglich aufsummiert werden.

Die Aufsummierung kann auf einfache Weise mit einem digitalen Totzeitglied realisiert werden, dessen Totzeit gleich der Abtastperiode des digitalen Auswertesystems ist und an dessen Eingang die Summe der Ausgangsspannung des Totzeitglieds und des um den ohmschen Spannungsabfall der Drehfeldmaschine verringerten jeweiligen digitalisierten Mittelwerts einer Klemmenspannung ansteht.

Das digitale Totzeitglied kann vorteilhafterweise ein digitaler Speicher sein, dessen Setzeingang mit einem gegenüber dem Haupttakt des digitalen Auswertesystems versetzten Übernahmetakt angesteuert wird. Das Totzeitglied kann damit auf einfache Weise mit einem handelsüblichen digitalen Speicher realisiert werden.

Zur Bildung eines gemittelten, digitalisierten Wertes von Klemmenspannung bzw. Leiterstrom können diese jeweils über einen integrierenden Analog/Digital-Wandler einem ersten digitalen Speicher zugeführt sein, dessen Ausgang mit dem ersten Eingang eines digitalen Subtrahierers und mit einem zweiten digitalen Speicher verbunden ist, wobei der Ausgang des zweiten digitalen Speichers mit dem zweiten Eingang des digitalen Subtrahierers verbunden ist, wobei der Ausgang des digitalen Subtrahierers mit dem Eingang eines dritten Speichers verbunden ist, an dessen Ausgang der gewünschte gemittelte digitalisierte Wert ansteht, wobei innerhalb jeder Taktperiode des digitalen Auswertesystems zuerst der erste Speicher, dann der dritte Speicher und schliesslich der zweite Speicher einen Setzimpuls erhält. Damit kann auch die Bildung der Mittelwerte von Klemmenspannungen und Leiterströmen mit einfachen, handelsüblichen Bauelementen erfolgen.

Der integrierende Digital/Analog-Wandler besteht vorteilhafterweise aus einem Spannungs-/Frequenz-Umsetzer mit nachgeschaltetem Zähler.

Dem Spannungs-/Frequenz-Umsetzer kann vorteilhafterweise ein Summierer vorgeschaltet sein, an dessen erstem Eingang die umzuwandelnde Grösse und an dessen zweitem Eingang eine Verschiebespannung ansteht, die grösser als der maximale negative Wert der Klemmenspannung ist und die so gewählt ist, dass sie innerhalb einer Abtastperiode des digitalen Auswertesystems einen Ablauf des nachgeschalteten Zählers verursacht. Damit wird also auf Grund der Verschiebespannung die Zählerkapazität genau einmal durchgezählt. Mit dieser Massnahme muss der Spannungs-/Frequenz-Umsetzer nur noch positive Grössen verarbeiten.

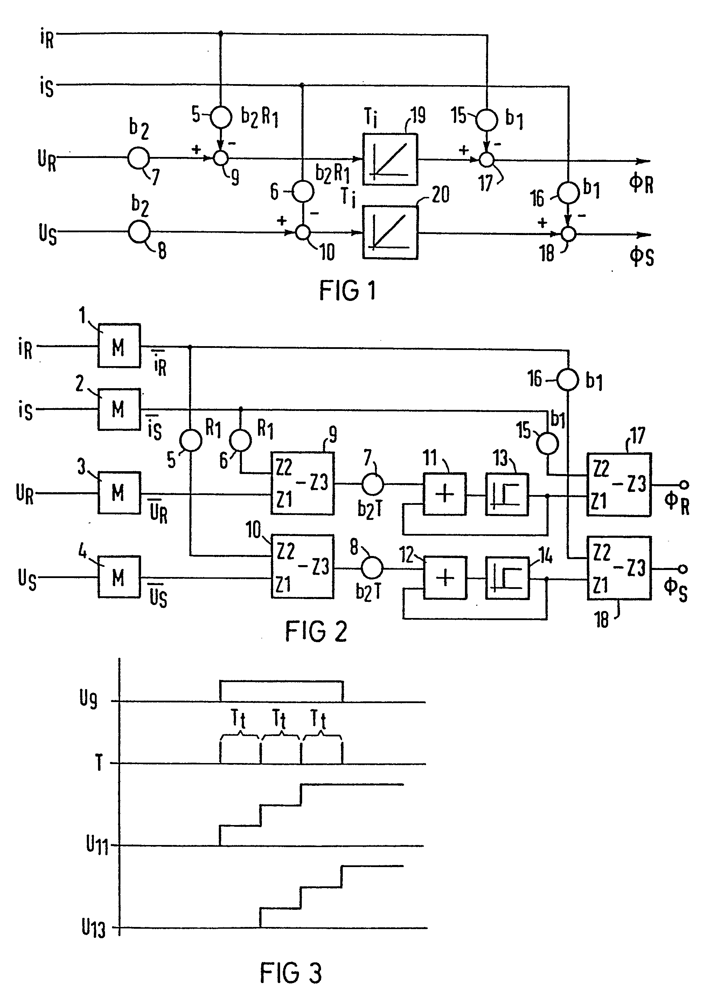

Ausführungsbeispiele der Erfindung werden nachfolgend anhand der Fig. 1 bis 6 näher erläutert.

Zunächst soll die mathematische Grundlage für das Verfahren erläutert werden. Wie bereits in der genannten DE-AS Nr. 2833593 dargestellt, erhält man jede Komponente des magnetischen Flusses im Rotor, indem man von der entsprechenden Komponente der Statorklemmenspannung den ohmschen Spannungsabfall subtrahiert, die Differenz aufintegriert und von diesem Wert wiederum den aufintegrierten induktiven Spannungsabfall subtrahiert:

$$\emptyset_R = b_2 \int_o^t (U_{1R} - i_{1R} R_1)\, dt - b_1 i_{1R} \qquad (1)$$

$$\emptyset_S = b_2 \int_o^t (U_{1S} - i_{1S} R_1)\, dt - b_1 i_{1S} \qquad (2)$$

Dabei ist:
$\emptyset_{R,S}$ die Komponente des Rotorflusses in Richtung der Phase R bzw. S des Stators der Drehfeldmaschine im 120°-Drehfeldsystem;
$i_{1R,S}$ die Komponente des Statorstroms in der Phase R bzw. S des Stators;
$U_{1R,S}$ die Statorklemmenspannung an der Phase R bzw. S des Stators;
$R_1$ der primäre Kupferwiderstand.

$b_1$ und $b_2$ sind als Abkürzungen für folgende Grössen gewählt, die aus der Maschinengleichung der Drehfeldmaschine abgeleitet werden können:

$$b_1 = l\sigma_1 + l\sigma_2 + \frac{l\sigma_1 l\sigma_2}{\tfrac{3}{4}\, l} \qquad (3)$$

$$b_2 = \frac{\tfrac{3}{2}\, l + l\sigma_2}{\tfrac{3}{2}\, l} \qquad (4)$$

Dabei ist:
$l\sigma_1$ die primäre Streuinduktivität;
$l\sigma_2$ die sekundäre Streuinduktivität;
$l$ die Hauptinduktivität.

Die Formeln 1 bis 4 liegen dem herkömmlichen analogen Spannungsmodell, wie es beispielsweise aus der DE-AS Nr. 2833593 bekannt ist, zugrunde. Fig. 1 zeigt ein Blockschaltbild dieses bekannten analogen Spannungsmodells. Die Klemmenspannungen $U_R$, $U_S$ der Phasen R und S des Maschinenstators werden über je einen Koeffizientenmultiplizierer 7 bzw. 8 einem Eingang je eines analogen Subtrahierers 9 bzw. 10 zugeführt. Die Ströme $i_R$ und $i_S$ in den Phasen R bzw. S des Stators werden über je einen Koeffizientenmultiplizierer 5 bzw. 6 jeweils dem zweiten Eingang der Subtrahierer 9 bzw. 10 zugeführt. Entsprechend den Gleichungen 1, 2 sind die Koeffizientenmultiplizierer 7 und 8 auf den Faktor $b_2$ und die Koeffizientenmultiplizierer 5 und 6 auf den Wert $b_2 R_1$ eingestellt. Mit den Subtrahierern 9 bzw. 10 wird also die Grösse $b_2 U_R - b_2 R_1 i_r$ bzw. $b_2 U_S - b_2 R_1 i_S$ gebildet. Die Ausgangssignale der Subtrahierer 9 bzw. 10 werden einem Integrierer 19 bzw. 20 zugeführt, der die genannten Differenzen entsprechend den Gleichungen 1, 2 aufintegriert. Die Ausgänge der Integrierer 19 und 20 sind jeweils mit einem Eingang eines zweiten analogen Subtrahierers 17 bzw. 18 verbunden. Die Ströme $i_R$ und $i_S$ sind über Koeffizientenmultiplizierer 15 bzw. 16 jeweils mit dem zweiten Eingang des Subtrahierers 17 bzw. 18 verbunden. Die Koeffizientenmultiplizierer 15 und 16 sind jeweils auf den Wert $b_1$ eingestellt, so dass entsprechend den Gleichungen 1, 2 von dem Integral der Wert $i_R b_1$ bzw. $i_S b_1$ subtrahiert wird. Damit sind die Gleichungen 1, 2 in eine analoge Rechenschaltung umgesetzt. Wie bereits erläutert, eignet sich jedoch ein Verfahren gemäss dem Blockschaltbild nach Fig. 1 nicht zur digitalen Realisierung, da insbesondere die Klemmenspannungen $U_R$ und $U_S$ nach der erforderlichen Digitalisierung mit grossen Fehlern behaftet wären, die durch die Integrierer 19 und 20 aufintegriert werden. Aus diesem Grund soll ein Verfahren zur Nachbildung des Maschinenflusses gefunden werden, das mit bereits aufintegrierten Werten arbeitet. Dazu werden in Gleichungen 1, 2 die Integrale zunächst durch die Summe der Mittelwerte ersetzt.

$$\emptyset_R = -i_R \cdot b_1 \tag{5}$$
$$+ \sum_{v=0}^{n} \left[ b_2 \int_{v \cdot T}^{(v+1)T} U_R \, dt - b_2 R_1 \int_{v \cdot T}^{(v+1)T} i_R dt \right]$$

$$\emptyset_S = -i_S \cdot b_1 \tag{6}$$
$$+ \sum_{v=0}^{n} \left[ b_2 \int_{v \cdot T}^{(v+1)T} U_S \, dt - b_2 R_1 \int_{v \cdot T}^{(v+1)T} i_S dt \right]$$

Hierbei ist $v$ die fortlaufende Nummer der Abtastperiode.

Die Gleichungen 5, 6 beschreiben noch das exakte Spannungsmodell. Die Augenblickswerte $i_R$ und $i_S$ werden jetzt durch die über eine Taktperiode eines zugeordneten digitalen Auswertesystems gemittelten Werte von $i_R$ und $i_S$ ersetzt. Da die Taktperioden im allgemeinen sehr kurz sind, ist der dadurch verursachte Fehler gering. Zur Abkürzung werden die Mittelwerte der Strangströme $i_R$ bzw. $i_S$ und der Klemmenspannungen $U_R$ bzw. $U_S$ mit einem Querstrich gekennzeichnet:

$$\emptyset_R \approx -b_1 \bar{i}_R (v) + b_2 T \sum_{v=0}^{n} \left[ \bar{U}_R (v) - R_1 \bar{i}_R (v) \right] \tag{7}$$

$$\emptyset_S \approx -b_1 \bar{i}_S (v) + b_2 T \sum_{v=0}^{n} \left[ \bar{U}_S (v) - R_1 \bar{i}_S (v) \right] \tag{8}$$

Fig. 2 zeigt ein Blockschaltbild, mit dem die Gleichungen 7, 8 realisiert sind. Dabei werden die Leiterströme $i_R$ und $i_S$ sowie die Klemmenspannungen $U_R$ und $U_S$ jeweils einem noch näher zu erläuternden Mittelwertbildner 1 bis 4 zugeführt, der daraus die digitalisierten Mittelwerte $\bar{i}_R$ und $\bar{i}_S$, $\bar{U}_R$ und $\bar{U}_S$ bildet. Die digitalisierten Mittelwerte der Ströme $\bar{i}_R$, $\bar{i}_S$ werden über Koeffizientenmultiplizierer 5 bzw. 6 dem Eingang Z2 der Subtrahierstufe 9 bzw. 10 zugeführt, die im Unterschied zu den Subtrahierstufen 9 und 10 beim analogen Blockschaltbild digital arbeiten. Der digitalisierte Mittelwert der Klemmenspannung $U_R$ bzw. $U_S$ ist im Ausführungsbeispiel dem Eingang Z1 der Subtrahierstufe 9 bzw. 10 direkt zugeführt. Die Integrierer 19 und 20 beim analogen Spannungsmodell sind durch die aus dem Summierer 11 und dem Totzeitglied 13 bzw. dem Summierer 12 und dem Totzeitglied 14 aufgebauten Aufsummierschaltung ersetzt. Die gemäss den Gleichungen 7 und 8 erforderliche Multiplikation mit dem Faktor $b_2 T$ erfolgt mit je einem zwischen die Subtrahierschaltungen 9 bzw. 10 und den Summierer 11 bzw. 12 geschalteten Koeffizientenmultiplizierer 7 bzw. 8. Da die Koeffizientenmultiplizierer 7 und 8 bereits den Faktor $b_2$ enthalten, sind die Koeffizientenmultiplizierer 5 und 6 im Unterschied zum analogen Spannungsmodell gemäss den Gleichungen 7, 8 lediglich auf den Faktor $R_1$ eingestellt. Die digitalen Koeffizientenmultiplizierer 15, 16 und Subtrahierschaltungen 17 und 18 entsprechen wieder den analogen Koeffizientenmultiplizierern 15 und 16 und Subtrahierschaltungen 17, 18.

Im folgenden wird anhand des Diagramms nach Fig. 3 die Funktion der aus den Summierern 11 bzw. 12 und den Totzeitgliedern 13 bzw. 14 bestehenden Aufsummierschaltungen erläutert. Aufgabe dieser Schaltungen ist es, wie bereits erläutert, die an den Ausgängen der Subtrahierschaltungen 9 und 10 anstehenden Differenzen der über jeweils eine Taktperiode gemittelten Werte der Leiterströme $i_R$, $i_S$ und der Klemmenspannungen $U_R$, $U_S$ aufzusummieren. Es sei angenommen, das beispielsweise am Ausgang des Subtrahierers 9 das in Fig. 3 mit $U_9$ bezeichnete Signal ansteht. Ferner wird angenommen, dass das mit $U_{13}$ bezeichnete Ausgangssignal des Totzeitgliedes 13 zunächst noch Null ist. Das mit $U_{11}$ bezeichnete Ausgangssignal des Summierers 11 stimmt daher zunächst mit dem Signal $U_9$ überein. Nach Ablauf der mit einer Taktperiode eines zugehörigen digitalen Auswertesystems übereinstimmenden Totzeit $T_t$ des Totzeitgliedes 13 erscheint dessen Eingangssignal auch am Ausgang und wird mit dem Summierer 11 zum Signal $U_9$ addiert. Somit wird nach Ablauf der Totzeit $T_t$ das während der zweiten Taktperiode anstehende Signal $U_9$ zu dem während der ersten Taktperiode anstehenden Signal $U_9$ addiert. Nach einem weiteren Ablauf der Totzeit $T_t$ erscheint das aufsummierte Signal wiederum am Ausgang des Totzeitgliedes 13 und wird wieder auf den Summierer 11 zurückgekoppelt. Damit erfolgt in der dritten Taktphase wiederum eine Aufsummierung des anstehenden Signals $U_9$, die sich nach dem dritten Ablauf der Totzeit auch am Ausgang des Totzeitgliedes 13 auswirkt. Wenn das Signal $U_9$ auf Null zurückgeht, so behält das Ausgangssignal des Totzeitgliedes 13 seinen Wert. Damit wurde also nachgewiesen, dass mit den aus der Summierschaltung 11 und dem Totzeitglied 13 bzw. der Summierschaltung 12 und dem Totzeitglied 14 zusammengesetzten Schaltungen die gewünschte Aufsummierung der digitalisierten, innerhalb einer Abtastperiode gemittelten Werte der Klemmenspannungen $U_R$, $U_S$ und der Leiterströme $i_R$, $i_S$ erfolgt.

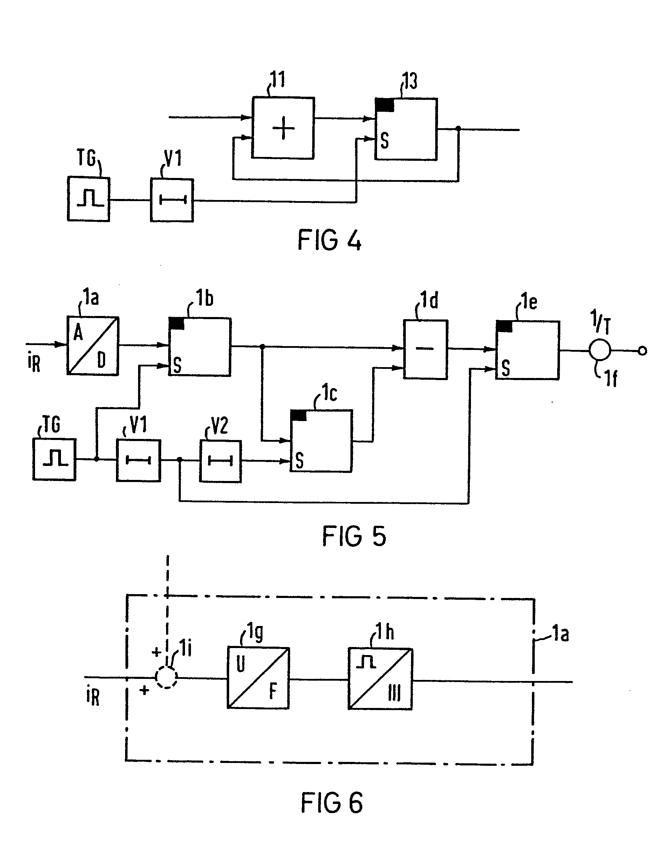

Die Totzeitglieder 13 und 14 können, wie das Ausführungsbeispiel nach Fig. 4 zeigt, beispielsweise mit je einem digitalen Speicher, z. B. 13 realisiert werden, dessen Setzeingang von einem Taktgeber TG eines zugeordneten digitalen Auswertesystems über eine Verzögerungsstufe V1 angesteuert werden. Damit wird nämlich kurze Zeit nach jedem Takt des Taktgebers TG das am Eingang des Speichers 13 anstehende Signal in den Speicher 13 übernommen, so dass genau das gewünschte Totzeitverhalten erreicht ist. Dabei stimmt die Totzeit mit der Taktperiode des Taktgebers TG überein. Eine Verzögerung der Übernahme gegenüber dem Takt des Taktgebers TG ist notwendig, damit die in demselben Takt erfolgende Mittelwertbildung der Eingangssignale beim Übernahmebefehl abgeschlossen ist.

Fig. 5 zeigt eine Realisierungsmöglichkeit für die Mittelwertbildner 1 bis 4. Dabei wird ein Eingangssignal, beispielsweise der Strangstrom $i_R$ dem Analogeingang eines integrierenden Analog/Digital-Wandlers 1a zugeführt. Am Digital-

ausgang des Analog/Digital-Wandlers 1a steht also der integrierte digitalisierte Wert des Eingangssignals $i_R$ an. Um daraus über eine Taktperiode gemittelte Werte des Eingangssignals $i_R$ zu bilden, muss jeweils die Differenz der Integrale des Eingangssignals $i_R$ bei zwei aufeinanderfolgenden Takten gebildet werden. Dazu ist der Digitalausgang des integrierenden Analog/Digital-Wandlers 1a mit den Speichereingängen eines Speichers 1b verbunden. Mit jedem Takt des Taktgebers TG, der mit dem Setzeingang des Speichers 1b verbunden ist, wird das anstehende Signal in den Speicher 1b übernommen. Der Ausgang des Speichers 1b ist mit dem Speichereingang eines Speichers 1c sowie mit einem Eingang einer Subtrahierschaltung 1d verbunden. Der Ausgang des Speichers 1c ist mit dem zweiten Eingang der Subtrahierschaltung 1d verbunden. Der Taktgeber TG wirkt über zwei in Reihe geschaltete Verzögerungsglieder V1 und V2 auf den Setzeingang des Speichers 1c. Da der Speicher 1c erst nach Ablauf der Verzögerungszeiten von V1 und V2 den Inhalt des Speichers 1b übernimmt, enthält er beim Auftreten eines Taktes noch den alten Eingangswert, während der Speicher 1b bereits auf den neuen Eingangswert gesetzt wird. Am Ausgang des Subtrahierers 1d steht also die Differenz zwischen dem Eingangswert in der neuen und dem Eingangswert in der vorhergehenden Taktperiode an. Der Ausgang der Subtrahierschaltung ist mit dem Speichereingang eines weiteren Speichers 1e verbunden, dessen Setzeingang mit dem Ausgang des Verzögerungsgliedes V1 verbunden ist. Damit übernimmt der Speicher 1e nach Ablauf der Verzögerungszeit V1 die gewünschte Differenz der integrierten Werte. Die Verzögerungsstufe V1 ist notwendig, um ein Setzen des Speichers 1b auf die neuen Eingangswerte vor der Abspeicherung der Differenz im Speicher 1e sicherzustellen. Nachdem die gewünschte Differenz im Speicher 1e abgespeichert ist, wird nach Ablauf der Verzögerungszeit des Verzögerungsgliedes V2 der Speicher 1c auf den neuen Wert gesetzt. Das Ausgangssignal des Speichers 1e muss lediglich mit einem Koeffizientenmultiplizierer 1f mit dem Faktor 1/T bewertet werden. Am Ausgang steht der gewünschte digitalisierte, über eine Taktperiode gemittelte Wert des Eingangssignals an.

Im Handel sind aber auch integrierende Analog/Digital-Wandler in Form von integrierten Schaltungen erhältlich, die ausgangsseitig einen über eine Abtastperiode gemittelten Wert der Eingangsspannung bilden. Für jeden Mittelwertbildner 1 bis 4 kann daher eine integrierte Schaltung eingesetzt werden.

Fig. 6 zeigt ein Ausführungsbeispiel für einen integrierenden Analog/Digital-Wandler 1a. Das umzuwandelnde Signal, beispielsweise der Leiterstrom $i_R$ wird dem Eingang eines Spannungs-/Frequenz-Umsetzers 1g zugeführt, dem ein Zähler 1h nachgeschaltet ist. Mit dem Zähler 1h werden die Impulse des Spannungs-/Frequenz-Umsetzers 1g aufsummiert, d. h. das digitale Integral der Eingangsgrösse $i_R$ gebildet. Mit diesem integrierenden Analog/Digital-Umsetzer ist sichergestellt, dass auch die Kommutierungsspitzen bei der Integralbildung mit erfasst werden. Ausserdem weist der Spannungs-/Frequenz-Umsetzer 1g nicht wie ein üblicher Analog/Digital-Wandler eine Stufung auf, die die Genauigkeit der Umsetzung bei kleinen Eingangswerten beeinträchtigen könnte.

Ohne zusätzliche Massnahmen muss der Spannungs-/Frequenz-Umsetzer 1g sowohl positive als auch negative Eingangswerte verarbeiten. Mit einem lediglich positive Werte verarbeitenden Spannungs-/Frequenz-Umsetzer 1g kommt man dagegen aus, wenn die Eingangsgrösse über einen in Fig. 6 gestrichelt eingezeichneten Summierer 1i zugeführt wird. An dessen zweitem Eingang steht ein Signal an, das grösser ist als der grösste negative Wert des Eingangssignals. Damit steht also am Spannungseingang des Spannungs-/Frequenz-Umsetzers 1g immer ein positives Signal an. Der am zweiten Eingang des Summierers 1i anstehende Wert ist ferner so gewählt, dass er innerhalb einer Abtastperiode des digitalen Auswertesystems einen Ablauf des nachgeschalteten Zählers 1h verursacht, d. h. für sich allein genau einmal die Zählerkapazität des Zählers 1g durchzählt. Damit bewirkt also das zum Eingangssignal addierte Signal für sich allein keine Veränderung des Zählerstandes.

Das erfindungsgemässe Verfahren kann gemäss dem Blockschaltbild nach Fig. 2 z. T. auch softwaremässig realisiert werden. Als Hardware sind lediglich integrierende Analog/Digital-Wandler, beispielsweise nach Fig. 6 erforderlich. Damit kann das beschriebene Verfahren besonders vorteilhaft für rechnergesteuerte Regelanlagen eingesetzt werden, wobei der Hardwareaufwand auf ein Minimum reduziert ist.

## Patentansprüche

1. Verfahren zur Nachbildung des Maschinenflusses einer Drehfeldmaschine aus den Klemmenspannungen und Leiterströmen mindestens zweier Phasen des Stators der Drehfeldmaschine, wobei zur Bildung jeder Komponente des Maschinenflusses eine um den ohmschen Spannungsabfall in einer Phase der Ständerwicklung der Drehfeldmaschine verringerte Klemmenspannung derselben Phase aufintegriert wird und von dem so gewonnenen Integral ein dem aufintegrierten induktiven Spannungsabfall in derselben Phase der Drehfeldmaschine entsprechender Wert subtrahiert wird, dadurch gekennzeichnet, dass die Nachbildung des Maschinenflusses ($\emptyset_R$, $\emptyset_S$) mit den digitalisierten, innerhalb der Abtastperiode (T) eines zugehörigen digitalen Auswertesystems gemittelten Werten der Klemmenspannungen ($\overline{U}_R$, $\overline{U}_S$) und der Leiterströme ($\overline{i}_R$, $\overline{i}_S$) durchgeführt wird, und dass die Integration durch Aufsummierung der gemittelten Werte und Multiplikation mit der Abtastperiode (T) erfolgt.

2. Schaltungsanordnung zur Durchführung eines Verfahrens nach Anspruch 1, dadurch gekennzeichnet, dass die Aufsummierung mit einem digitalen Totzeitglied (13, 14) erfolgt, dessen Totzeit ($T_t$) gleich der Abtastperiode (T) des digitalen Auswertesystems ist, an dessen Eingang die Summe der Ausgangsspannung des Totzeitgliedes (13, 14) und des um den ohmschen Spannungsabfall der Drehfeldmaschine verringerten jeweiligen digitalisierten Mittelwerts einer Klemmenspannung ($\overline{U}_R$, $\overline{U}_S$) ansteht.

3. Schaltungsanordnung zur Durchführung eines Verfahrens nach Anspruch 2, dadurch gekennzeichnet, dass jedes digitale Totzeitglied (13, 14) ein digitaler Speicher ist, dessen Setzeingang (S) mit einem gegenüber dem Haupttakt des digitalen Auswertesystems versetzten Übernahmetakt angesteuert wird.

4. Schaltungsanordnung nach einem der Ansprüche 2 oder 3, dadurch gekennzeichnet, dass zur Bildung eines gemittelten digitalisierten Werts von Klemmenspannung ($\overline{U}_R$, $\overline{U}_S$) bzw. Leiterstrom ($\bar{i}_R$, $\bar{i}_S$) diese jeweils über einen integrierenden Analog/Digital-Wandler (1a) einem ersten digitalen Speichers (1b) zugeführt sind, dessen Ausgang mit dem ersten Eingang eines digitalen Subtrahierers (1d) und mit einem zweiten digitalen Speicher (1c) verbunden ist, dass der Ausgang des zweiten digitalen Speichers (1c) mit dem zweiten Eingang des digitalen Subtrahierers (1d) verbunden ist, und dass der Ausgang des digitalen Subtrahierers (1d) mit dem Eingang eines dritten Speichers (1e) verbunden ist, an dessen Ausgang der gewünschte gemittelte digitalisierte Wert ansteht, wobei innerhalb jeder Taktperiode (T) des digitalen Auswertesystems zuerst der erste Speicher (1b), dann der dritte Speicher (1e) und schliesslich der zweite Speicher (1c) einen Setzimpuls erhält.

5. Schaltungsanordnung nach Anspruch 4, dadurch gekennzeichnet, dass der integrierende Analog/Digital-Wandler (1a) aus einem Spannungs-/Frequenz-Umsetzer (1g) mit nachgeschaltetem Zähler (1h) besteht.

6. Schaltungsanordnung nach Anspruch 5, dadurch gekennzeichnet, dass dem Spannungs-/Frequenz-Umsetzer (1g) ein Summierer (1i) vorgeschaltet ist, an dessen erstem Eingang die umzuwandelnde Grösse und an dessen zweitem Eingang eine Verschiebespannung ansteht, die grösser ist als der maximale negative Wert der Klemmenspannung und die so gewählt ist, dass sie innerhalb einer Abtastperiode des digitalen Auswertesystems einen Ablauf des nachgeschalteten Zählers verursacht.

## Claims

1. A method of simulating the machine flux of an induction machine from the terminal voltages and conductor currents of at least two phases of the stator of the induction machine, where each component of the machine flux is formed from a terminal voltage that is reduced by the ohmic voltage drop in one phase of the stator winding of the induction machine and integrated in the same phase, and a value corresponding to the integrated, inductive voltage drop in the same phase of the induction machine is subtracted from the thus obtained integral, characterized in that the simulation of the machine flux ($\emptyset_R$, $\emptyset_S$) is carried out using digitalised values of terminal voltages ($\overline{U}_R$, $\overline{U}_S$) and the conductor currents ($\bar{i}_R$, $\bar{i}_S$) averaged within the sampling period (T) of an associated digital analysis system, and in that the integration is carried out by adding the averaged values and multiplying them by the sampling period (T).

2. A circuit arrangement for carrying out the method as claimed in Claim 1, characterised in that the addition is effected by means of a digital delay element (13, 14) whose dead time ($T_t$) is equal to the sampling period (T) of the digital analysis system at whose input there occurs the sum of the output voltage of the delay element (13, 14) and of the digitalised mean value of a terminal voltage ($\overline{U}_R$, $\overline{U}_S$) reduced by the ohmic voltage drop of the induction machine.

3. A circuit arrangement for carrying out the method as claimed in Claim 2, characterised in that each digital delay element (13, 14) is a digital store whose set input (S) is driven by a transfer clock pulse train offset relative to the main clock pulse train of the digital analysis system.

4. A circuit arrangement as claimed in Claim 2 or 3, characterised in that, for the formation of an averaged digitalised value of the terminal voltage ($\overline{U}_R$, $\overline{U}_S$) and of the conductor current ($\bar{i}_R$, $\bar{i}_S$), each are fed *via* an integrating and analogue/digital converter (1a) to a first digital store (1b) whose output is connected to the first input of a digital subtractor (1d) and to a second digital store (1c), in that the output of the second digital store (1c) is connected to the second input of the digital subtractor (1d), and in that the output of the digital subtractor (1d) is connected to the input of a third store (1e) at whose output there occurs the desired, averaged, digitalised value, where, within each clock pulse period (T) of the digital analysis system, firstly the first store (1b), then the third store (1e), and finally the second store (1c) obtains a set pulse.

5. A circuit arrangement as claimed in Claim 4, characterised in that the integrating analogue/digital converter (1a) consists of a voltage/frequency converter (1g) followed by a counter (1h).

6. A circuit arrangement as claimed in Claim 5, characterised in that the voltage/frequency converter (1g) is preceded by an adder (1i) at whose first input there occurs the value to be converted, and at whose second input there occurs a shift voltage greater than the maximum negative value of the terminal voltage and selected to be such that within a sampling period of the digital analysis system it brings about one functional sequence of the following counter.

## Revendications

1. Procédé pour simuler le flux magnétique dans une machine à champ magnétique tournant à partir des tensions aux bornes et des courants dans les conducteurs d'au moins deux phases du stator de la machine à champ tournant, selon lequel, pour former chaque composante du flux dans la machine, on détermine l'intégrale de la tension aux bornes d'une phase, diminuée de la chute de tension ohmique dans la même phase de l'enroulement statorique de la machine, et on déduit de l'intégrale ainsi obtenue une valeur de la machine correspondant à la chute de tension inductive intégrée dans la même phase, caractérisé en ce que l'on simule le flux magnétique ($\emptyset_R$, $\emptyset_S$) dans la machine au moyen des valeurs numérisées des tensions aux bornes ($\overline{U}_R$, $\overline{U}_S$) et des courants (dans les conducteurs) de phase ($\overline{i}_R$, $\overline{i}_S$), dont les moyennes sont établies dans la période d'échantillonnage (T) d'un système numérique d'exploitation associé, et en ce que l'intégration s'effectue par totalisation des moyennes et par multiplication par la période d'échantillonnage (T).

2. Montage pour la mise en œuvre d'un procédé selon la revendication 1, caractérisé en ce que la totalisation s'effectue au moyen d'un élément numérique à temps de retard (13, 14) dont le temps de retard ($T_t$) égale la période d'échantillonnage (T) du système numérique d'exploitation, à l'entrée duquel est appliquée la somme de la tension de sortie de l'élément à temps de retard (13, 14) et de la valeur moyenne correspondante, numérisée, d'une tension aux bornes ($\overline{U}_R$, $\overline{U}_S$), diminuée de la chute de tension ohmique de la machine.

3. Montage pour la mise en œuvre d'un procédé selon la revendication 2, caractérisé en ce que chaque élément numérique à temps de retard (13, 14) est une mémoire numérique dont l'entrée de commande (S) est attaquée par un signal périodique de reprise décalé par rapport au signal périodique principal du système numérique d'exploitation.

4. Montage selon l'une des revendications 2 ou 3, caractérisé en ce que, pour la formation d'une valeur moyenne numérisée de la tension aux bornes ($\overline{U}_R$, $\overline{U}_S$) ou du courant de phase ($\overline{i}_R$, $\overline{i}_S$), la valeur de tension ou de courant est appliquée chaque fois à travers un convertisseur analogique/numérique (1a) formant intégrateur à une première mémoire numérique (1b) dont la sortie est reliée à la première entrée d'un soustracteur numérique (1d) et à une seconde mémoire numérique (1c), en ce que la sortie de la seconde mémoire numérique (1c) est reliée à la seconde entrée du soustracteur (1d) et en ce que la sortie du soustracteur (1d) est reliée à l'entrée d'une troisième mémoire (1e), à la sortie de laquelle apparaît la valeur numérique moyenne désirée, l'agencement étant tel que, dans chaque période d'horloge (T) du système numérique d'exploitation, d'abord la première mémoire (1b) reçoit une impulsion de commande de mémorisation, puis la troisième mémoire (1e) et enfin la seconde mémoire (1c).

5. Montage selon la revendication 4, caractérisé en ce que le convertisseur analogique/numérique (1a) formant intégrateur est constitué d'un convertisseur tension/fréquence (1g) à la suite duquel est monté un compteur (1h).

6. Montage selon la revendication 5, caractérisé en ce que le convertisseur tension/fréquence (1g) est précédé d'un totalisateur (1i), à la première entrée duquel est appliquée la grandeur à convertir et à la seconde entrée duquel est appliquée une tension de décalage qui est plus élevée que la valeur négative maximale de la tension aux bornes et qui est choisie de telle manière qu'elle entraîne l'exécution d'un cycle de comptage complet du compteur monté à la suite à l'intérieur d'une période d'échantillonnage du système d'exploitation numérique.

FIG 1

FIG 2

FIG 3

FIG 4

FIG 5

FIG 6